# EUROPEAN PATENT APPLICATION

(11) **EP 1 193 765 A2**
(43) Date of publication of application: **03.04.2002**
(21) Application number: 01121731.2
(22) Date of filing: 18.09.2001
(51) Int. Cl.: H01L 29/08, H01L 29/78, H01L 21/336, H01L 21/331

(54) **Power semiconductor device**

(30) Priority: 02.10.2000 JP 2000301999
(71) Applicant: Kabushiki Kaisha Toshiba, Tokyo (JP)
(72) Inventor: Ninomiya, Hideaki, Park-Heim-Sakuradai-201, Yokohama-shi, Kanagawa-ken (JP); Inoue, Tomoki, Ota-ku, Tokyo-to (JP); Omura, Ichiro, Yokohama-shi, Kanagawa-ken (JP); Yamaguchi, Masakazu, Furukawa-Kazoka-Apartment 533, Kawasaki-shi, Kanagawa-ken (JP)
(74) Representative: HOFFMANN - EITLE

(57) **Abstract**

This invention forms an N-type source layer by self-alignment in a vertical trench IGBT, vertical trench MOSFET, lateral trench IGBT, and lateral trench MOSFET. This decreases the diffused resistance in a P-type base layer to increase the latch-up breakdown voltage, and also lowers the ON voltage by micropatterning of the device.

## Description

### BACKGROUND OF THE INVENTION

The present invention relates to a power semiconductor device, and more particularly, to a power semiconductor device having a trench type MOS gate structure.

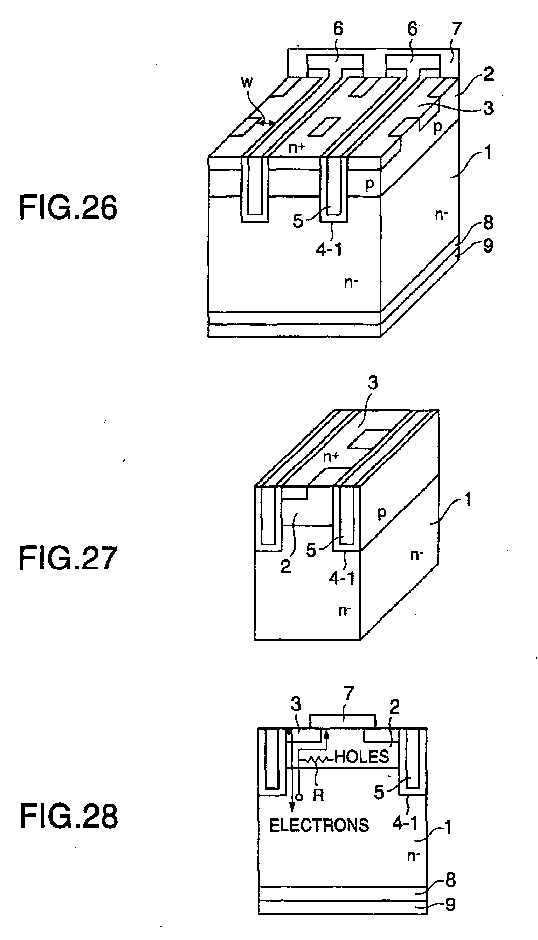

Fig. 26 is a perspective view of a vertical IGBT (Insulated Gate Bipolar Transistor) having a trench gate structure related to the present invention.

In this trench IGBT related to the present invention, a P-type base layer 2 is formed by diffusion on the surface of an N-type base layer 1, and an N-type source layer 3 is selectively formed on the surface of the P-type base layer 2. After that, trenches for MOS gates are formed and covered with a gate insulating film 4-1. Gate electrodes 5 are buried in these trenches, and an insulating film 6 is deposited to cover the trenches.

Subsequently, contact widows are formed, and an emitter electrode 7 is finally formed on the surface to complete a MOS gate structure.

In this trench type MOS gate structure related to the present invention, the N-type source layer 3 is formed into a ladder-like shape so as to be connected to the emitter electrode 7. To this end, a width w of the N-type source layer 3 for forming MOS channels must be increased by taking account of a mask alignment margin. If mask misalignment occurs, as shown in Fig. 27, a MOS channel is formed only on one side of the trench. This decreases the channel width and increases the ON resistance of the MOS.

If w is increased by taking a margin, as shown in Fig. 28, a diffused resistance R of the P-type base layer 2 immediately below the N-type source layer 3 increases. A hole current flows through this diffused resistance R when the device is turned on. If this R is high, therefore, the potential immediately below the N-type source layer 3 rises, so latch-up readily occurs. Also, micropatterning of the device becomes difficult, and this makes it difficult to reduce the ON voltage.

As described above, in the fabrication process of the trench type IGBT related to the present invention, a margin is necessary to align masks for trench formation and N-type source layer formation in order to lower the ON voltage. However, if an excessively large margin is taken, the latch-up breakdown voltage lowers. This makes it difficult to lower the ON voltage by decreasing the spacing between trenches.

Accordingly, a demand for a power semiconductor device having a high latch-up breakdown voltage is increasing.

### SUMMARY OF THE INVENTION

A power semiconductor device according to the present invention comprises a first-conductivity-type base layer, a second-conductivity-type base layer formed on the first-conductivity-type base layer, a trench extending from a surface of the second-conductivity-type base layer to the first-conductivity-type base layer, a first-conductivity-type source layer selectively formed along the trench on the second-conductivity-type base layer, a gate electrode formed, via a gate insulating film, on the second-conductivity-type base layer sandwiched between the first-conductivity-type base layer and the first-conductivity-type source layer in the trench, and a first main electrode electrically connected to the first-conductivity-type source layer and the second-conductivity-type base layer, wherein the first-conductivity-type source layer is formed on side walls of the trench without any mask alignment.

This structure is common to a vertical trench IGBT, vertical trench MOSFET, lateral trench IGBT, and lateral trench MOSFET.

The vertical trench IGBT further comprises a second-conductivity-type emitter layer formed on a surface of the first-conductivity-type base layer away from a surface on which the second-conductivity-type base layer is formed, and a second main electrode electrically connected to the second-conductivity-type emitter layer.

The vertical trench MOSFET further comprises a first-conductivity-type drain layer formed on a surface of the first-conductivity-type base layer away from a surface on which the second-conductivity-type base layer is formed, and a second main electrode electrically connected to the first-conductivity-type drain layer.

The lateral trench IGBT further comprises a second-conductivity-type emitter layer selectively formed on a surface of the first-conductivity-type base layer on which the second-conductivity-type base layer is formed, and a second main electrode electrically connected to the second-conductivity-type emitter layer.

The lateral trench MOSFET further comprises a first-conductivity-type drain layer selectively formed on a surface of the first-conductivity-type base layer on which the second-conductivity-type base layer is formed, and a second main electrode electrically connected to the first-conductivity-type drain layer.

### BRIEF DESCRIPTION OF THE DRAWINGS

Figs. 1A to 1D are perspective views showing a trench gate structure according to the first embodiment of the present invention;
Figs. 2A to 2D are perspective views showing a trench gate structure according to the second embodiment of the present invention;
Figs. 3A to 3D are perspective views showing a trench gate structure according to the third embodiment of the present invention;
Fig. 4 is a perspective view showing a trench gate structure according to the fourth embodiment of the present invention;
Figs. 5A to 5D are perspective views showing a trench gate structure according to the fifth embodiment of the present invention;
Fig. 6 is a perspective view showing a trench gate structure according to the sixth embodiment of the present invention;
Fig. 7 is a perspective view showing a trench gate structure according to the seventh embodiment of the present invention;
Fig. 8 is a perspective view showing a trench gate structure according to the eighth embodiment of the present invention;
Fig. 9 is a perspective view showing a trench gate structure according to the ninth embodiment of the present invention;
Fig. 10 is a perspective view showing a trench gate structure according to the 10th embodiment of the present invention;
Fig. 11 is a perspective view showing a trench gate structure according to the 11th embodiment of the present invention;
Fig. 12 is a perspective view showing a trench gate structure according to the 12th embodiment of the present invention;
Fig. 13 is a perspective view showing a trench gate structure according to the 13th embodiment of the present invention;
Fig. 14 is a perspective view showing a trench gate structure according to the 14th embodiment of the present invention;
Fig. 15 is a perspective view showing a trench gate structure according to the 15th embodiment of the present invention;
Fig. 16 is a perspective view showing a trench gate structure according to the 16th embodiment of the present invention;
Fig. 17 is a perspective view showing a trench gate structure according to the 17th embodiment of the present invention;
Fig. 18 is a perspective view showing a trench gate structure according to the 18th embodiment of the present invention;
Fig. 19 is a perspective view showing a trench gate structure according to the 19th embodiment of the present invention;
Fig. 20 is a perspective view showing a trench gate structure according to the 20th embodiment of the present invention;
Fig. 21 is a perspective view showing a trench gate structure according to the 21st embodiment of the present invention;
Fig. 22 is a perspective view showing a trench gate structure according to the 22nd embodiment of the present invention;
Fig. 23 is a perspective view showing a trench gate structure according to the 23rd embodiment of the present invention;
Fig. 24 is a perspective view showing a trench gate structure according to the 24th embodiment of the present invention;
Fig. 25 is a perspective view showing a trench gate structure according to the 25th embodiment of the present invention;
Fig. 26 is a perspective view showing a trench gate structure related to the present invention;
Fig. 27 is a perspective view showing the problem of the trench gate structure related to the present invention; and
Fig. 28 is a sectional view showing the operation when a trench type IGBT related to the present invention is ON.

### DESCRIPTION OF THE PREFERRED EMBQDIMENTS

Embodiments of the present invention will be described below with reference to the accompanying drawings.

The following embodiments will be explained by taking a vertical trench gate structure as an example. However, the present invention is not limited to this structure and is applicable to general power semiconductor devices having trench type MOS gate structures, such as a vertical trench IGBT, lateral trench IGBT, vertical trench MOSFET, and lateral trench MOSFET.

In the following embodiments, the first and second conductivity types described in the scope of claims are N and p types, respectively.

### (First Embodiment)

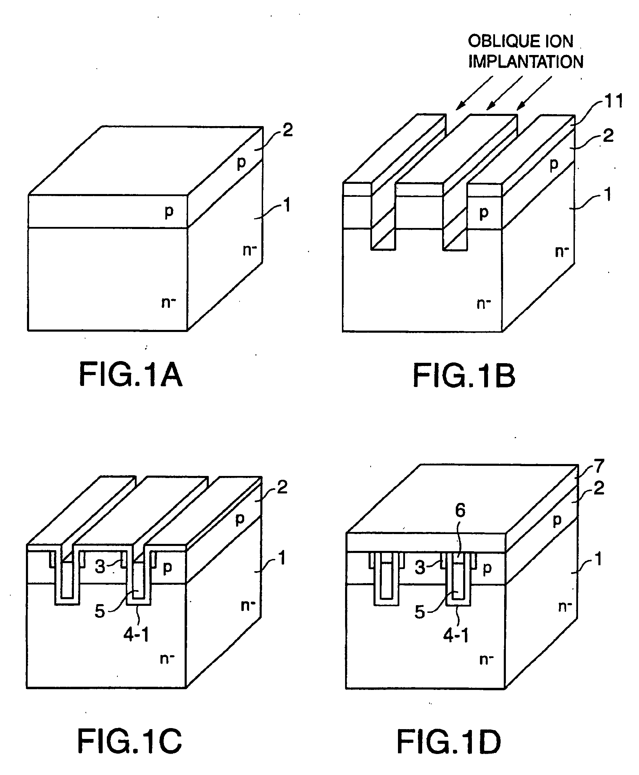

Figs. 1A to 1D are perspective views showing the fabrication steps of a trench type MOS gate structure according to the first embodiment of the present invention.

The same reference numerals as in Figs. 26 to 28 denote the same parts in Fig. 1, and a detailed description thereof will be omitted.

First, a P-type base layer 2 is formed by diffusion on the surface of an N-type base layer 1 (Fig. 1A).

Next, a mask insulating film 11 is deposited and patterned. This pattern of the mask insulating film 11 is used as a mask material to form trenches. After that, ion implantation is performed to a predetermined depth by adjusting the angle (Fig. 1B).

The mask insulating film 11 is removed, and an N-type source layer 3 is formed by a diffusion step. Gate electrodes 5 are buried in the trenches via a gate insulating film 4-1.

In addition, portions of the gate electrodes 5 are etched back to a predetermined depth from the surface of the P-type base layer 2 (Fig. 1C).

After that, an insulating film 6 is so deposited as to protect the upper portions of the gate electrodes 5. This insulating film 6 and the gate insulating film 4-1 are etched until the surface of the P-type base layer 2 is exposed.

Subsequently, an emitter electrode 7 is formed to be electrically connected to the N-type source layer 3 (Fig. 1D).

As described above, the characteristic feature of this embodiment is that the N-type source layer 3 is formed on the side walls of the trenches without any alignment margin.

In this embodiment, the N-type source layer 3 can be formed by self-alignment, so no mask alignment margin is necessary.

Accordingly, the diffused resistance R, shown in Fig. 28, of the P-type base layer 2 decreases, and the latch-up breakdown voltage increases.

### (Second Embodiment)

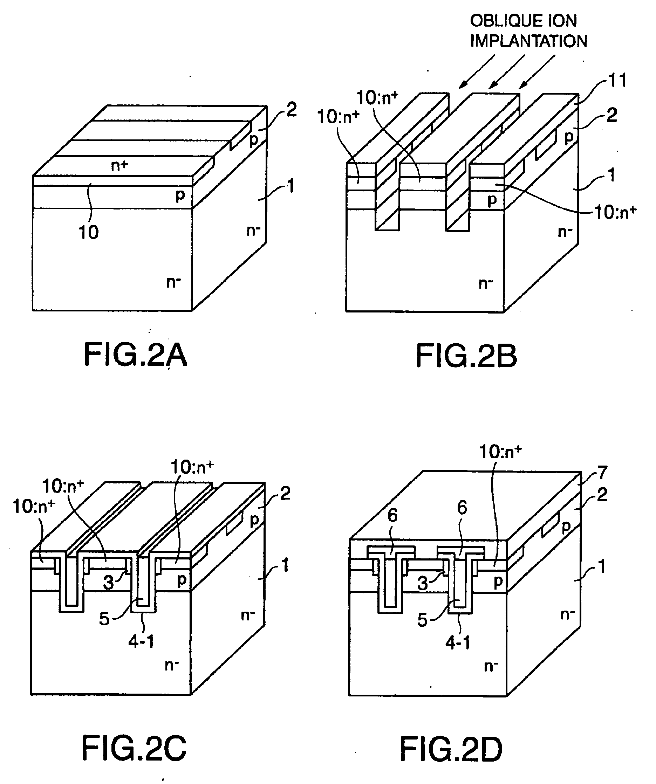

Figs. 2A to 2D are perspective views showing the fabrication steps of a trench type MOS gate structure according to the second embodiment of the present invention.

First, a P-type base layer 2 is formed by diffusion on the surface of an N-type base layer 1, and an N-type contact layer 10 is selectively formed by diffusion on the surface of the P-type base layer 2 (Fig. 2A).

Next, a mask insulating film 11 is deposited and patterned. This pattern of the mask insulating film 11 is used as a mask material to form trenches. After that, ion implantation is performed to a predetermined depth by adjusting the angle (Fig. 2B).

The mask insulating film 11 is removed, and an N-type source layer 3 is formed by a diffusion step. Gate electrodes 5 are buried in the trenches via a gate insulating film 4-1.

In addition, portions of the gate electrodes 5 are etched back (Fig. 2C).

After that, an insulating film 6 is so deposited as to protect the upper portions of the gate electrodes 5. Contact windows are formed, and an emitter electrode 7 is formed to be electrically connected to the N-type contact layer 10 (Fig. 2D).

The characteristic feature of this embodiment is that the M-type source layer 3 and the emitter electrode 7 are electrically connected via the N-type contact layer 10.

By this method, the N-type source layer 3 and the emitter electrode 7 can be electrically connected without using any buried gate structure as shown in Fig. 1D of the first embodiment.

Also, since the area by which the emitter electrode 7 is connected to the N-type contact layer 10 can be increased, the ON voltage of the device can be lowered.

Furthermore, the N-type source layer 3 and the N-type contact layer 10 are separately formed. Therefore, a portion where an impurity must be diffused deep to ensure the formation of channels in the aforementioned ladder-like structure related to the present invention can be made shallow like the N-type contact layer 10.

Consequently, diffusion in the lateral direction of the N-type contact layer 10 can be shortened, and this makes micropatterning of the device in a direction parallel to the trenches feasible.

### (Third Embodiment)

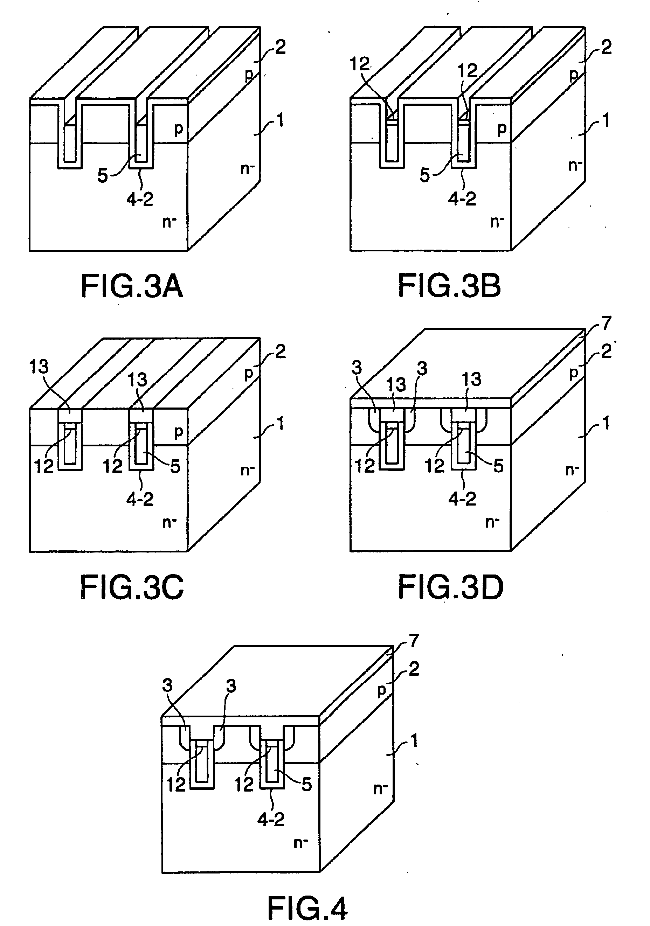

Figs. 3A to 3D are perspective views showing the fabrication steps of a trench type MOS gate structure according to the third embodiment of the present invention.

Fig. 3A shows the state in which gate electrodes 5 are buried in trenches through steps similar to Figs. 1A to 1C of the first embodiment.

Unlike the first embodiment, however, no N-type source layer 3 is formed, and a gate insulating film 4-2 is an ONO film (a multilayered film of oxide film - nitride film - oxide film).

When an oxidation step is performed in this state, almost no oxidation progresses on the nitride film, and a thick oxide film 12 is formed only on the gate electrodes 5 (Fig. 3B).

After that, the gate insulating film 4-2 is removed by etching except for portions below the oxide film 12 protecting the gate electrodes 5.

In addition, a PSG film (phosphosilicate glass film) 13 is deposited and so etched back as to remain in the trenches (Fig. 3C).

Next, a diffusion step is performed to diffuse phosphorous from this PSG film 13 to form an N-type source layer 3. After that, an emitter electrode 7 is formed to be electrically connected to the N-type source layer 3 (Fig. 3D).

In this embodiment, the N-type source layer 3 can be formed by self-alignment, and the device has a buried gate structure. This allows finer micropatterning of the device than conventional devices.

As a consequence, the latch-up breakdown voltage rises, so a device having a low ON voltage can be fabricated.

### (Fourth Embodiment)

Fig. 4 is a perspective view showing the fabrication step of a trench type MOS gate structure according to the fourth embodiment of the present invention.

In this embodiment, after the same steps as Figs. 3A to 3C explained in the third embodiment are performed, a diffusion step is performed to diffuse phosphorous from a PSG film 13, thereby forming an N-type source layer 3 on the side walls of trenches.

After that, the PSG film 13 in the trenches is removed by etching back, and an emitter electrode 7 is so formed as to fill the trenches (Fig. 4).

In the structure of this embodiment, unlike the third embodiment, the N-type source layer 3 and the emitter electrode 7 are also connected on the side walls of the trenches. Since this decreases the contact resistance, the ON voltage can be further lowered.

### (Fifth Embodiment)

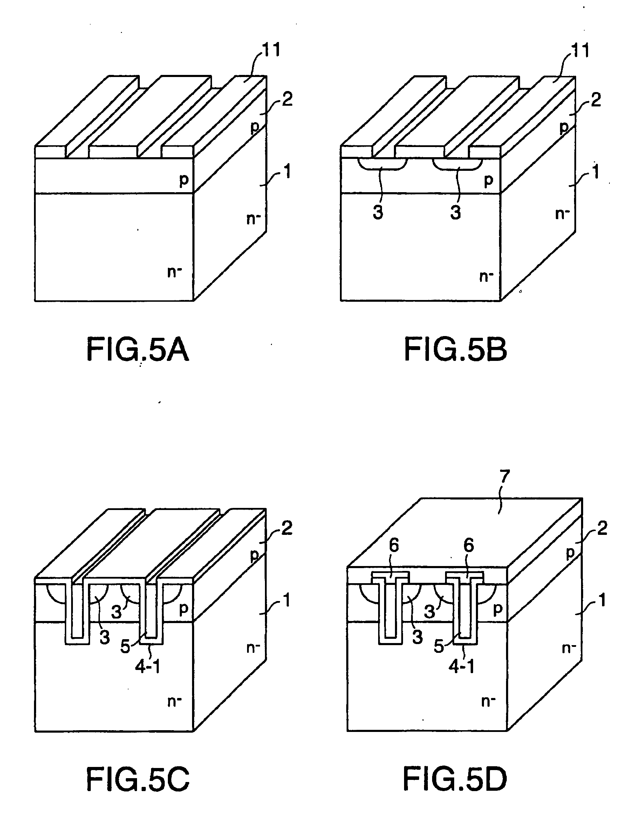

Figs. 5A to 5D are perspective views showing the fabrication steps of a trench type MOS gate structure according to the fifth embodiment of the present invention.

First, a P-type base layer 2 is formed by diffusion on an N-type base layer 1.

On this P-type base layer 2, a mask insulating film 11 for forming trenches is selectively formed (Fig. 5A).

After that, ion implantation and diffusion are performed to form an N-type source layer 3 (Fig. 5B).

In addition, trenches are formed by etching, and a gate insulating film 4-2 is deposited on the inner surfaces of these trenches. Gate electrodes 5 are then buried in the trenches.

These gate electrodes 5 are partially etched back (Fig. 5C).

An insulating film 6 is so deposited as to protect the upper portions of the gate electrodes 5, contact windows are formed, and an emitter electrode 7 is formed to be electrically connected to the N-type source layer 3 (Fig. 5D).

In this embodiment, similar to the other embodiments, the N-type source layer 3 can be formed by self-alignment. This can improve the latch-up breakdown voltage and realize micropatterning of the device.

The first to fifth embodiments described above have the gate structure common to a vertical trench IGBT, vertical trench MOSFET, lateral trench IGBT, and lateral trench MOSFET. The sixth to 10th embodiments of the present invention described below are vertical trench IGBTS having the gate structures of the first to fifth embodiments, respectively. Likewise, the 11th to 15th embodiments, 16th to 20th embodiments, and 21st to 25th embodiments are vertical MOSFETs, horizontal IGBTs, and lateral trench MOSFETs having the structures of the first to fifth embodiments, respectively.

### (Sixth Embodiment)

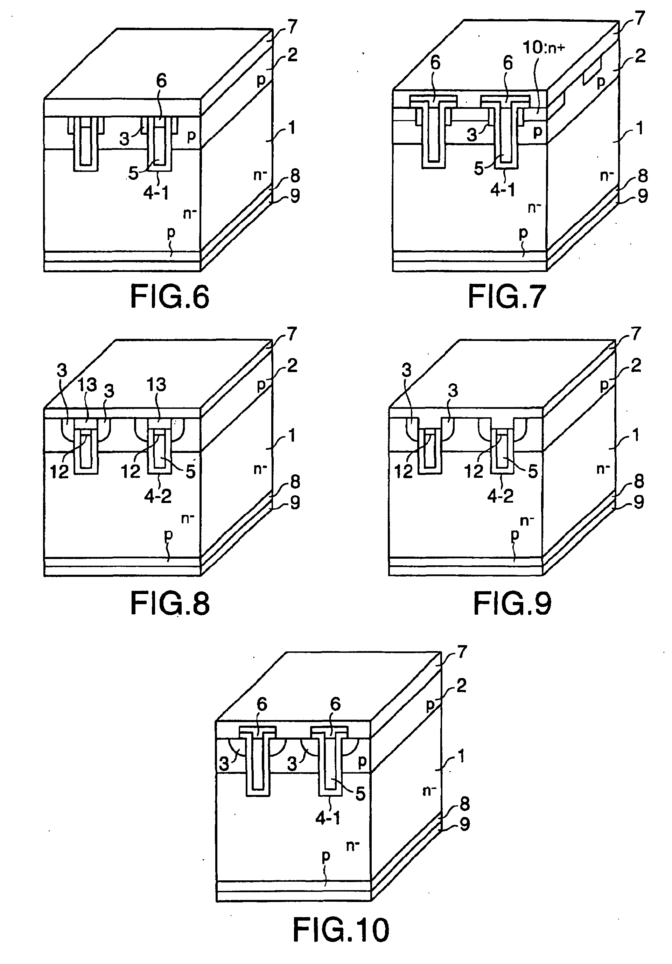

A vertical trench IGBT according to the sixth embodiment of the present invention has a structure shown in Fig. 6.

This embodiment includes, in addition to the gate structure shown in Figs. 1A to 1D, a P-type emitter layer 8 formed on the surface of an N-type base layer 1 away from the surface on which a base layer 2 is formed, and an emitter electrode 9 electrically connected to this P-type emitter layer 8.

### (Seventh Embodiment)

A vertical trench IGBT according to the seventh embodiment of the present invention has a structure shown in Fig. 7.

This embodiment includes, in addition to the gate structure shown in Figs. 2A to 2D, a P-type emitter layer 8 formed on the surface of an N-type base layer 1 away from the surface on which a base layer 2 is formed, and an emitter electrode 9 electrically connected to this P-type emitter layer 8.

### (Eighth Embodiment)

A vertical trench IGBT according to the eighth embodiment of the present invention has a structure shown in Fig. 8.

This embodiment includes, in addition to the gate structure shown in Figs. 3A to 3D, a P-type emitter layer 8 formed on the surface of an N-type base layer 1 away from the surface on which a base layer 2 is formed, and an emitter electrode 9 electrically connected to this P-type emitter layer 8.

### (Ninth Embodiment)

A vertical trench IGBT according to the ninth embodiment of the present invention has a structure shown in Fig. 9.

This embodiment includes, in addition to the gate structure shown in Fig. 4, a P-type emitter layer 8 formed on the surface of an N-type base layer 1 away from the surface on which a base layer 2 is formed, and an emitter electrode 9 electrically connected to this P-type emitter layer 8.

### (10th Embodiment)

A vertical trench IGBT according to the 10th embodiment of the present invention has a structure shown in Fig. 10.

This embodiment includes, in addition to the gate structure shown in Figs. 5A to 5D, a P-type emitter layer 8 formed on the surface of an N-type base layer 1 away from the surface on which a base layer 2 is formed, and an emitter electrode 9 electrically connected to this P-type emitter layer 8.

### (11th Embodiment)

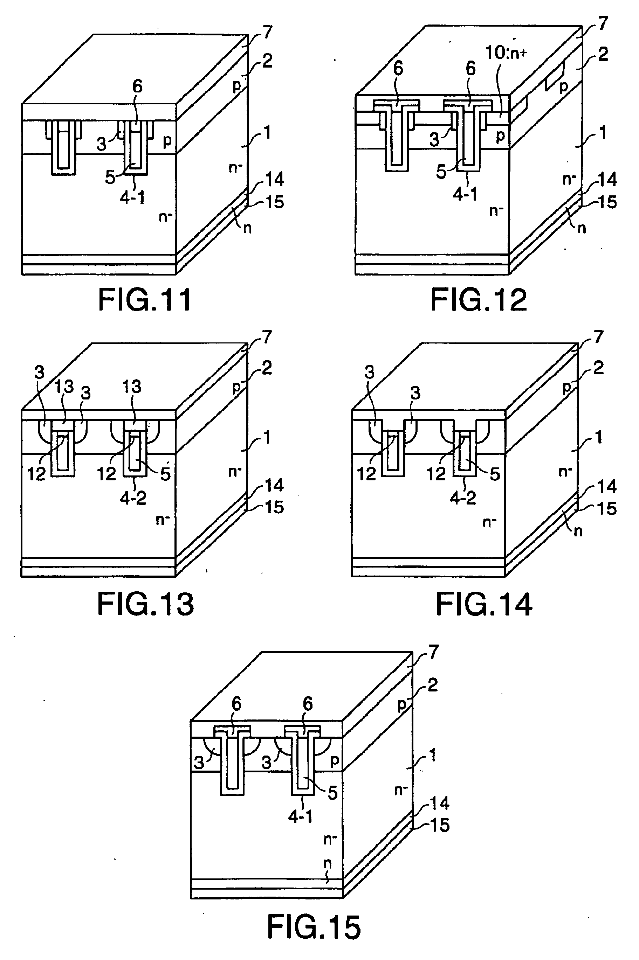

A vertical trench MOSFET according to the 11th embodiment of the present invention has a structure shown in Fig. 11.

This embodiment includes, in addition to the gate structure shown in Figs. 1A to 1D, an N-type drain layer 14 formed on the surface of an N-type base layer 1 away from the surface on which a base layer 2 is formed, and a drain electrode 15 electrically connected to this N-type drain layer 14.

### (12th Embodiment)

A vertical trench MOSFET according to the 12th embodiment of the present invention has a structure shown in Fig. 12.

This embodiment includes, in addition to the gate structure shown in Figs. 2A to 2D, an N-type drain layer 14 formed on the surface of an N-type base layer 1 away from the surface on which a base layer 2 is formed, and a drain electrode 15 electrically connected to this N-type drain layer 14.

### (13th Embodiment)

A vertical trench MOSFET according to the 13th embodiment of the present invention has a structure shown in Fig. 13.

This embodiment includes, in addition to the gate structure shown in Figs. 3A to 3D, an N-type drain layer 14 formed on the surface of an N-type base layer 1 away from the surface on which a base layer 2 is formed, and a drain electrode 15 electrically connected to this N-type drain layer 14.

### (14th Embodiment)

A vertical trench MOSFET according to the 14th embodiment of the present invention has a structure shown in Fig. 14.

This embodiment includes, in addition to the gate structure shown in Fig. 4, an N-type drain layer 14 formed on the surface of an N-type base layer 1 away from the surface on which a base layer 2 is formed, and a drain electrode 15 electrically connected to this N-type drain layer 14.

### (15th Embodiment)

A vertical trench MOSFET according to the 15th embodiment of the present invention has a structure shown in Fig. 15.

This embodiment includes, in addition to the gate structure shown in Figs. 5A to 5D, an N-type drain layer 14 formed on the surface of an N-type base layer 1 away from the surface on which a base layer 2 is formed, and a drain electrode 15 electrically connected to this N-type drain layer 14.

### (16th Embodiment)

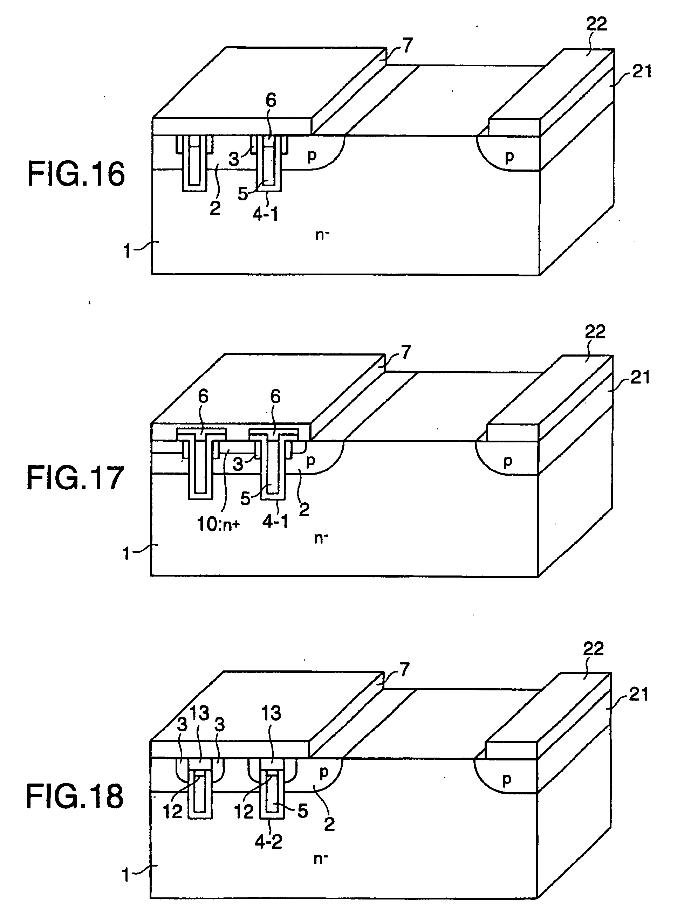

A lateral trench IGBT according to the 16th embodiment of the present invention has a structure shown in Fig. 16.

This embodiment includes, in addition to the gate structure shown in Figs. 1A to 1D, a P-type emitter layer 21 formed on the surface of an N-type base layer 1 on which a base layer 2 is formed, and an emitter electrode 22 electrically connected to this P-type emitter layer 21.

### (17th Embodiment)

A lateral trench IGBT according to the 17th embodiment of the present invention has a structure shown in Fig. 17.

This embodiment includes, in addition to the gate structure shown in Figs. 2A to 2D, a P-type emitter layer 21 formed on the surface of an N-type base layer 1 on which a base layer 2 is formed, and an emitter electrode 22 electrically connected to this P-type emitter layer 21.

### (18th Embodiment)

A lateral trench IGBT according to the 18th embodiment of the present invention has a structure shown in Fig. 18.

This embodiment includes, in addition to the gate structure shown in Figs. 3A to 3D, a P-type emitter layer 21 formed on the surface of an N-type base layer 1 on which a base layer 2 is formed, and an emitter electrode 22 electrically connected to this P-type emitter layer 21.

### (19th Embodiment)

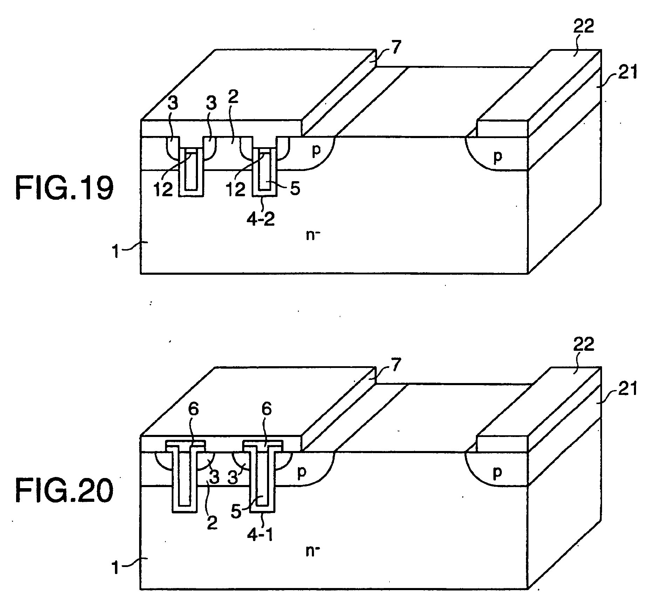

A lateral trench IGBT according to the 19th embodiment of the present invention has a structure shown in Fig. 19.

This embodiment includes, in addition to the gate structure shown in Fig. 4, a P-type emitter layer 21 formed on the surface of an N-type base layer 1 on which a base layer 2 is formed, and an emitter electrode 22 electrically connected to this P-type emitter layer 21.

### (20th Embodiment)

A lateral trench IGBT according to the 20th embodiment of the present invention has a structure shown in Fig. 20.

This embodiment includes, in addition to the gate structure shown in Figs. 5A to 5D, a P-type emitter layer 21 formed on the surface of an N-type base layer 1 on which a base layer 2 is formed, and an emitter electrode 22 electrically connected to this P-type emitter layer 21.

### (21st Embodiment)

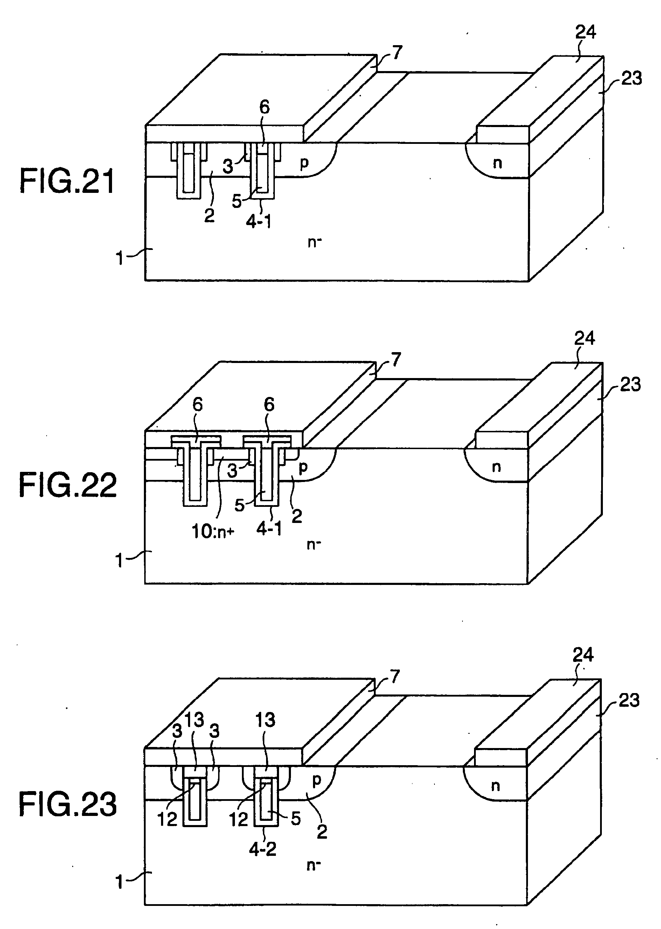

A lateral trench MOSFET according to the 21st embodiment of the present invention has a structure shown in Fig. 21.

This embodiment includes, in addition to the gate structure shown in Figs. 1A to 1D, an N-type drain layer 23 formed on the surface of an N-type base layer 1 on which a base layer 2 is formed, and a drain electrode 24 electrically connected to this N-type drain layer 23.

### (22nd Embodiment)

A lateral trench MOSFET according to the 22nd embodiment of the present invention has a structure shown in Fig. 22.

This embodiment includes, in addition to the gate structure shown in Figs. 2A to 2D, an N-type drain layer 23 formed on the surface of an N-type base layer 1 on which a base layer 2 is formed, and a drain electrode 24 electrically connected to this N-type drain layer 23.

### (23rd Embodiment)

A lateral trench MOSFET according to the 23rd embodiment of the present invention has a structure shown in Fig. 23.

This embodiment includes, in addition to the gate structure shown in Figs. 3A to 3D, an N-type drain layer 23 formed on the surface of an N-type base layer 1 on which a base layer 2 is formed, and a drain electrode 24 electrically connected to this N-type drain layer 23.

### (24th Embodiment)

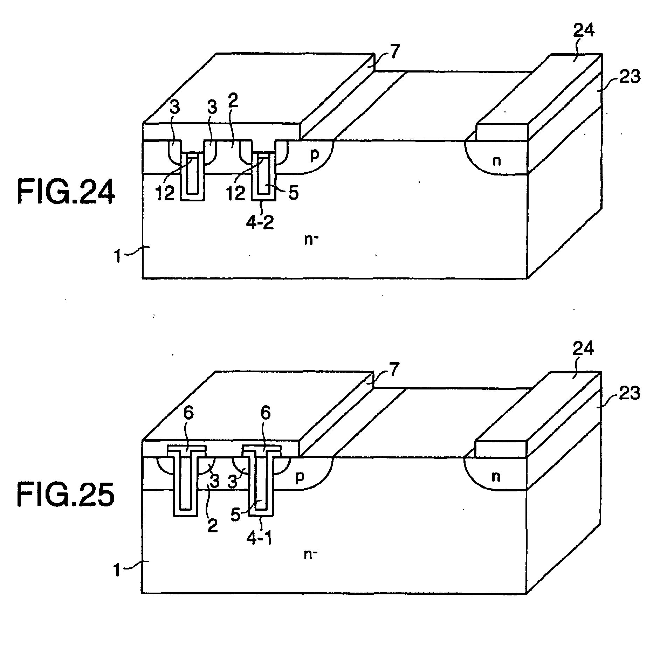

A lateral trench MOSFET according to the 24th embodiment of the present invention has a structure shown in Fig. 24.

This embodiment includes, in addition to the gate structure shown in Fig. 4, an N-type drain layer 23 formed on the surface of an N-type base layer 1 on which a base layer 2 is formed, and a drain electrode 24 electrically connected to this N-type drain layer 23.

### (25th Embodiment)

A lateral trench MOSFET according to the 25th embodiment of the present invention has a structure shown in Fig. 25.

This embodiment includes, in addition to the gate structure shown in Figs. 5A to 5D, an N-type drain layer 23 formed on the surface of an N-type base layer 1 on which a base layer 2 is formed, and a drain electrode 24 electrically connected to this N-type drain layer 23.

In each of the above embodiments, a first-conductivity-type source layer can be formed by self-alignment in a power semiconductor device having a trench type MOS structure. This can eliminate an alignment margin between a trench and an N-type source layer and raise the latch-up breakdown voltage. In addition, it is possible to realize micropatterning of the device and lower the ON voltage.

## Claims

1. A power semiconductor device comprising:
a first-conductivity-type base layer;
a second-conductivity-type base layer formed on said first-conductivity-type base layer;
a trench extending from a surface of said second-conductivity-type base layer to said first-conductivity-type base layer;
a first-conductivity-type source layer selectively formed along said trench on said second-conductivity-type base layer;
a gate electrode formed, via a gate insulating film, on said second-conductivity-type base layer sandwiched between said first-conductivity-type base layer and said first-conductivity-type source layer in said trench; and
a first main electrode electrically connected to said first-conductivity-type source layer and said second-conductivity-type base layer,
wherein said first-conductivity-type source layer is formed on side walls of said trench without any mask alignment.

2. A device according to claim 1, wherein said first-conductivity-type source layer and said first main electrode are electrically connected by a first-conductivity-type contact layer selectively formed on said second-conductivity-type base layer.

3. A device according to claim 1, wherein in said trench, an impurity-doped glass layer is deposited on an insulating film formed on said gate electrode, and said first-conductivity-type source layer is formed by diffusion from said glass layer.

4. A device according to claim 1, wherein in said trench, said first main electrode is formed on said insulating film attached on top of said gate electrode, and said first main electrode and said first-conductivity-type source layer are electrically connected on side walls of said trench.

5. A device according to claim 1, wherein said first-conductivity-type source layer is formed by diffusion by using as a mask a mask material for forming said trench.

6. A device according to claim 1, further comprising:
a second-conductivity-type emitter layer formed on a surface of said first-conductivity-type base layer away from a surface on which said second-conductivity-type base layer is formed; and
a second main electrode electrically connected to said second-conductivity-type emitter layer.

7. A device according to claim 6, wherein said first-conductivity-type source layer and said first main electrode are electrically connected by a first-conductivity-type contact layer selectively formed on said second-conductivity-type base layer.

8. A device according to claim 6, wherein in said trench, an impurity-doped glass layer is deposited on an insulating film formed on said gate electrode, and said first-conductivity-type source layer is formed by diffusion from said glass layer.

9. A device according to claim 6, wherein in said trench, said first main electrode is formed on said insulating film attached on top of said gate electrode, and said first main electrode and said first-conductivity-type source layer are electrically connected on side walls of said trench.

10. A device according to claim 6, wherein said first-conductivity-type source layer is formed by diffusion by using as a mask a mask material for forming said trench.

11. A device according to claim 1, further comprising:
a first-conductivity-type drain layer formed on a surface of said first-conductivity-type base layer away from a surface on which said second-conductivity-type base layer is formed; and
a second main electrode electrically connected to said first-conductivity-type drain layer.

12. A device according to claim 11, wherein said first-conductivity-type source layer and said first main electrode are electrically connected by a first-conductivity-type contact layer selectively formed on said second-conductivity-type base layer.

13. A device according to claim 11, wherein in said trench, an impurity-doped glass layer is deposited on an insulating film formed on said gate electrode, and said first-conductivity-type source layer is formed by diffusion from said glass layer.

14. A device according to claim 11, wherein in said trench, said first main electrode is formed on said insulating film attached on top of said gate electrode, and said first main electrode and said first-conductivity-type source layer are electrically connected on side walls of said trench.

15. A device according to claim 11, wherein said first-conductivity-type source layer is formed by diffusion by using as a mask a mask material for forming said trench.

16. A device according to claim 1, further comprising:
a second-conductivity-type emitter layer selectively formed on a surface of said first-conductivity-type base layer on which said second-conductivity-type base layer is formed; and
a second main electrode electrically connected to said second-conductivity-type emitter layer.

17. A device according to claim 16, wherein said first-conductivity-type source layer and said first main electrode are electrically connected by a first-conductivity-type contact layer selectively formed on said second-conductivity-type base layer.

18. A device according to claim 16, wherein in said trench, an impurity-doped glass layer is deposited on an insulating film formed on said gate electrode, and said first-conductivity-type source layer is formed by diffusion from said glass layer.

19. A device according to claim 16, wherein in said trench, said first main electrode is formed on said insulating film attached on top of said gate electrode, and said first main electrode and said first-conductivity-type source layer are electrically connected on side walls of said trench.

20. A device according to claim 16, wherein said first-conductivity-type source layer is formed by diffusion by using as a mask a mask material for forming said trench.

21. A device according to claim 1, further comprising:
a first-conductivity-type drain layer selectively formed on a surface of said first-conductivity-type base layer on which said second-conductivity-type base layer is formed; and
a second main electrode electrically connected to said first-conductivity-type drain layer.

22. A device according to claim 21, wherein said first-conductivity-type source layer and said first main electrode are electrically connected by a first-conductivity-type contact layer selectively formed on said second-conductivity-type base layer.

23. A device according to claim 21, wherein in said trench, an impurity-doped glass layer is deposited on an insulating film formed on said gate electrode, and said first-conductivity-type source layer is formed by diffusion from said glass layer.

24. A device according to claim 21, wherein in said trench, said first main electrode is formed on said insulating film attached on top of said gate electrode, and said first main electrode and said first-conductivity-type source layer are electrically connected on side walls of said trench.

25. A device according to claim 21, wherein said first-conductivity-type source layer is formed by diffusion by using as a mask a mask material for forming said trench.
